# EUROPEAN PATENT APPLICATION

(11) **EP 4 691 653 A1**
(43) Date of publication of application: **11.02.2026**
(21) Application number: 25757943.3
(22) Date of filing: 18.02.2025
(51) Int. Cl.: B05D 3/00, B05C 5/00, B05C 11/00, B05C 11/10, B05C 13/02

(54) **METHOD AND DEVICE FOR DETECTING LIQUID POOL AT LOWER END OF NOZZLE**

(30) Priority: 22.02.2024 JP 2024025847
(71) Applicant: Musashi Engineering, Inc., Mitaka-shi, Tokyo 181-0011 (JP)
(72) Inventor: IKUSHIMA, Kazumasa, Mitaka-shi, Tokyo 181-0011 (JP)
(74) Representative: TBK
(86) International application number: PCT/JP2025/005275
(87) International publication number: WO 2025/178006

(57) **Abstract**

Problem: To provide a technology that enables easy and highly-accurate determination on a pool that has occurred at a bottom end of a nozzle.

Solution: Provided is a nozzle bottom pool detection method in a liquid material discharge device, the method including: a first process of moving a nozzle 103 to a sensing position above a sensing surface; a second process of moving the nozzle 103 downward until an interval between a bottom end of the nozzle 103 and the sensing surface 107a becomes equal to a predetermined sensing distance L and moving the nozzle 103 upward upon the interval reaching the predetermined sensing distance L; and a third process of detecting a pool at the bottom end of the nozzle 103 by a sensing device 104 sensing whether a liquid material adheres to the sensing surface 107a. Also provided is a detection device that executes the same method.

## Description

### Technical Field

The present invention relates to a method and device for detecting whether there is a pool of liquid material at a bottom end of a nozzle in a liquid material application apparatus.

### Background Art

In a process of manufacturing electronic components or the like, a discharge device is used for application of liquid material. For example, a dispenser is used in a process of applying a liquid resin to a semiconductor element mounted on a board. When the dispenser performs successive application on workpieces, a pool of the liquid may occur at a nozzle tip, which affects application accuracy. Particularly, a flying-discharge type dispenser, which is recently becoming more common, is affected by the liquid pooling at a nozzle tip, and sometimes suffers from troubles such as the liquid not separating from the nozzle to fly, an excessively large or small amount of flying liquid, and the liquid not flying along the central axis of the nozzle.

Conventionally, a pool at a nozzle tip has been dealt with using a method in which a camera for monitoring a nozzle tip from a lateral side is provided to sense abnormality of the nozzle tip in an image (Patent Document 1), a method in which trial application is performed on a plate that is not an application target and is monitored by a camera to determine whether or not an application amount is appropriate (Patent Document 2), or the like.

### Prior Art List

### Patent Document

Patent Document 1: Japanese Patent Laid-Open Publication No. 2014-236136
Patent Document 2: Japanese Patent Laid-Open Publication No. H4-334568

### Summary of the Invention

### Problems to be Solved by the Invention

However, the method of capturing an image of a nozzle tip to determine whether a pool is within an acceptable range has an issue that, when a pool occurs at a bottom end of the nozzle, it is difficult to determine whether the volume exceeds the acceptable range. In addition, the method of capturing an image of a nozzle tip to determine whether a liquid pool is within an acceptable range has an issue that it is necessary to secure an installation location of a camera that captures the nozzle tip from a lateral side and to set up an optical system for monitoring.

On the other hand, the method of performing trial application to determine whether it is appropriate or not has an issue that a normal application result differs little from an abnormal application result and it is difficult to determine whether the volume of a pool at the bottom end of the nozzle exceeds the acceptable range.

An object of the present invention is to provide a technology that enables easy and highly-accurate determination on a pool that has occurred at a bottom end of a nozzle.

### Means for Solving the Problems

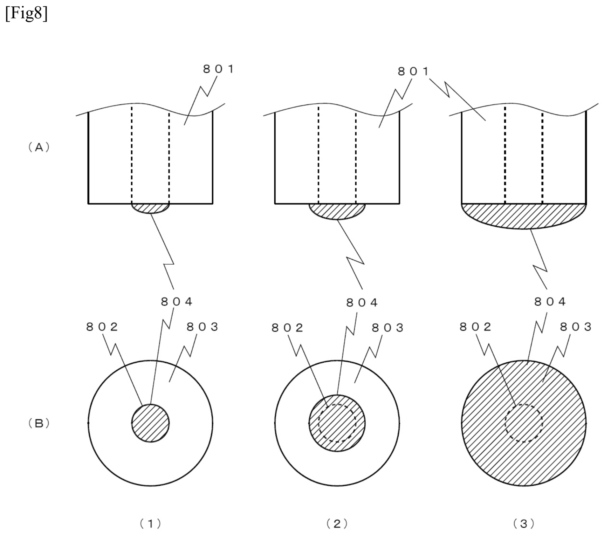

In a flying-discharge type dispenser, when discharge is successively performed, a liquid pool emerges at a nozzle tip (especially bottom surface), and may gradually spread all over the tip. Fig. 8 is a schematic diagram for explaining how a pool emerges and develops at a nozzle tip, where (A) illustrates lateral views of a nozzle 801, and (B) illustrates bottom views of the nozzle 801. The nozzle 801 has a cylindrical shape and includes, at its end, a hole portion 802 from which a liquid material 804 is discharged, and a wall portion 803 surrounding the hole portion 802. Soon after a pool of the liquid 804 emerges, it spreads to a dimension roughly equal to the diameter of the hole portion 802 (Fig. 8 (1)). When discharge is successively performed and the volume of the pool of the liquid 804 increases, the pool begins to spread beyond the hole portion 802 to the wall portion 803 (Fig. 8 (2)). When discharge is further successively performed and the volume of the pool of the liquid 804 has increased, the pool spreads all over the wall portion 803 to reach the outer periphery (Fig. 8 (3)).

The inventor has gained the following insight while conducting research and has conceived the present invention based on the insight.

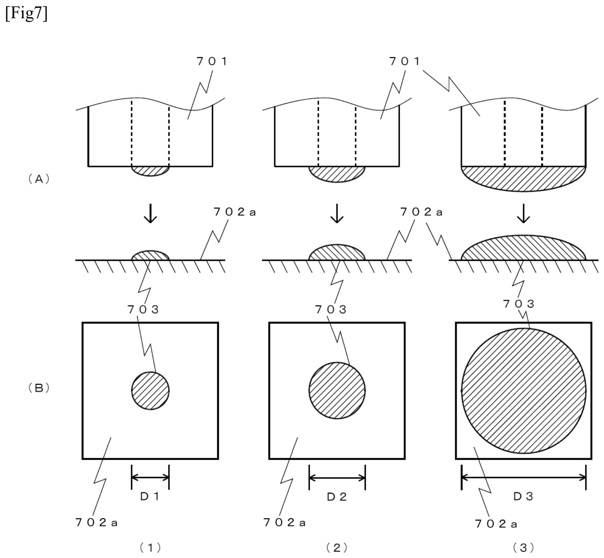

Fig. 7 is a schematic diagram for explaining a method of sensing a pool through trial application, where (A) illustrates lateral views of a nozzle 701 and an application surface 702, and (B) illustrates top views of the application surface 702. In Fig. 7, (1) illustrates a state of a pool 703 immediately after it emerges, (2) illustrates a state of the pool 703 beginning to develop, and (3) illustrates a state of the pool 703 covering a large part of the nozzle 701. In the method by trial application illustrated in Fig. 7, determination on a pool is performed, for example, depending on the diameter of the liquid material 703 applied to the application surface 702 as a result of executing the trial application. In the method by trial application, an application result when the pool has developed (diameter D3) greatly differs from an application result when the pool begins to develop (diameter D2), allowing for easy determination. However, the application result when the pool begins to develop (diameter D2) differs little from an application result immediately after the pool emerges, that is, an almost normal application result (diameter D1), leading to the determination becoming more difficult even if image processing is performed on a captured image. Accordingly, the method by trial application entails risks of overlooking the state of the pool beginning to develop (Fig. 7 (2)) and continuing to perform abnormal application.

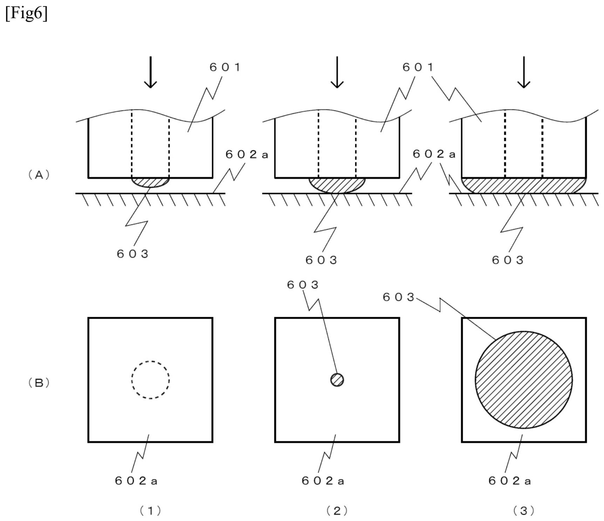

Fig. 6 illustrates a schematic diagram for explaining a method of sensing a pool according to the present invention. (A) illustrates lateral views of a nozzle 601 and a sensing surface 602a, and (B) illustrates top views of the sensing surface 602a. (1) illustrates a state of a pool 603 immediately after it emerges, (2) illustrates a state of the pool 603 beginning to develop, and (3) illustrates a state of the pool 603 covering a large part of the nozzle 601. In the method of the present invention illustrated in Fig. 6, as described in detail later, determination on a pool is performed depending on whether the liquid material 603 adheres to the sensing surface 602a. According to the method of the present invention, both of an execution result when a pool has developed (Fig. 6 (3)) and an execution result when the pool begins to develop (Fig. 6 (2)) show that the liquid material 603 adheres to the sensing surface 602a. Meanwhile, an execution result immediately after the pool emerges, or an execution result at normal times (Fig. 6 (1)) shows that the liquid material 603 does not adhere to the sensing surface 602a. Accordingly, the method of the present invention enables highly-accurate sensing even in the state of the pool beginning to develop ((2)) and can prevent application from continuing with an unacceptable pool remaining at a nozzle tip.

A nozzle bottom pool detection method according to the present invention includes the following technical means.
[1] A nozzle bottom pool detection method for detecting a pool at a bottom end of a nozzle of a liquid material discharge device, the nozzle bottom pool detection method including: a first process of moving the nozzle to a sensing position above a sensing surface; a second process of moving the nozzle downward until an interval between the bottom end of the nozzle and the sensing surface becomes equal to a predetermined sensing distance and moving the nozzle upward upon the interval reaching the predetermined sensing distance; and a third process of detecting a pool at the bottom end of the nozzle by a sensing device sensing whether a liquid material adheres to the sensing surface.
[2] The nozzle bottom pool detection method according to [1], wherein the liquid material is not discharged from the nozzle during execution of the second process.
[3] The nozzle bottom pool detection method according to [1] or [2], wherein the nozzle is a nozzle having one discharge port at the bottom end.
[4] The nozzle bottom pool detection method according to any one of [1] to [3], wherein the nozzle is a nozzle having a cylindrical or tapered shape.
[5] The nozzle bottom pool detection method according to any one of [1] to [4], wherein the sensing device is any of an image capturing device, a laser displacement meter, and an ultrasonic sensor.
[6] The nozzle bottom pool detection method according to any one of [1] to [5], wherein the sensing surface is any of an upper surface of a plate-like member for sensing, an upper surface of a tape-like member, and an unused area of an upper surface of a workpiece.
[7] The nozzle bottom pool detection method according to any one of [1] to [6], wherein the predetermined sensing distance is set within a range of 1/2 to 2 times an outer diameter of the bottom end of the nozzle, or 1/3 to 7 times a diameter of a discharge port of the nozzle.
[8] A liquid material application method including: an application process of discharging a liquid material from the nozzle to a workpiece; and a pool detection process of executing the nozzle bottom pool detection method according to any one of [1] to [7] before or after executing the application process.
[9] The liquid material application method according to [8], further including a process of cleaning the bottom end of the nozzle when it has been detected in the pool detection process that the liquid material adheres to the sensing surface.
[10] The liquid material application method according to [9], including a post-cleaning application process of discharging the liquid material from the nozzle to the workpiece after executing the cleaning.
[11] The liquid material application method according to [8], further including, when a pool of which volume is not acceptable has been detected at the bottom end of the nozzle in the pool detection process, issuing an alert that can be visually or aurally recognized or transmitting a command signal to notify an external device of abnormality, and stopping execution of the application process.
[12] The liquid material application method according to any one of [8] to [11], further including: an importing process of importing the workpiece to an application position, the importing process being performed before the application process; and an exporting process of exporting the workpiece from the application position, the exporting process being performed after the application process, wherein the pool detection process is executed concurrently with any of the importing process and the exporting process.
   A nozzle bottom pool detection device according to the present invention includes the following technical means.
[13] A nozzle bottom pool detection device including: a moving device configured to move a discharge device having a nozzle above a sensing surface; a sensing device configured to sense a liquid material having adhered to the sensing surface; and a sensing control device configured to control operation of the moving device and the sensing device, wherein the sensing control device is configured to execute: a first step of causing the moving device to move the nozzle above the sensing surface; a second step of causing the nozzle to move downward until an interval between a bottom end of the nozzle and the sensing surface becomes equal to a predetermined sensing distance and move upward upon the interval reaching the predetermined sensing distance; and a third step of causing the sensing device to sense whether the liquid material adheres to the sensing surface thereby detecting a pool at the bottom end of the nozzle.
[14] The nozzle bottom pool detection device according to [13], wherein the sensing control device includes a function of setting the predetermined sensing distance.
[15] The nozzle bottom pool detection device according to [13] or [14], wherein the moving device is capable of moving the sensing device above the sensing surface.
   An application apparatus according to the present invention includes the following technical means.
[16] An application apparatus including: the nozzle bottom pool detection device according to any one of [13] to [15]; a discharge device having a nozzle; a worktable configured to hold a workpiece; a base on which the worktable is disposed; a transport device configured to transport the workpiece to the worktable; and an application control device configured to control operation of the discharge device and the moving device, wherein the application apparatus performs application on the workpiece while causing the moving device to move the discharge device and the workpiece relative to each other based on a relative movement command from the application control device.
[17] The application apparatus according to [16], further including, on the base, a cleaning device configured to clean the bottom end of the nozzle, wherein the sensing control device is configured to execute a fourth step of causing the cleaning device to clean the bottom end of the nozzle when it has been detected in the third step that the liquid material adheres to the sensing surface.
[18] The application apparatus according to [16], further including a notification device configured to issue an alert that can be visually or aurally recognized, wherein the sensing control device is configured to execute a fourth step of causing the notification device to issue the alert when it has been detected in the third step that the liquid material adheres to the sensing surface.
[19] The application apparatus according to any one of [16] to [18], wherein the sensing control device includes a function of setting a timing-related condition for executing the first to third steps.
[20] The application apparatus according to any one of [16] to [19], wherein the discharge device is a flying-discharge type dispenser configured to discharge and fly a droplet from a discharge port of the nozzle.

### Advantageous Effect of the Invention

According to the present invention, it becomes possible to perform easy and highly-accurate determination on a pool having occurred at a bottom end of a nozzle.

### Brief Description of the Drawings

[Fig. 1] Fig. 1 is a block diagram of a pool detection device according to embodiments.
[Fig. 2] Fig. 2 is a flowchart of a pool detection method according to embodiments.
[Fig. 3] Fig. 3 is an explanatory diagram for explaining the pool detection method according to embodiments.
[Fig. 4] Fig. 4 is a perspective view of an application apparatus according to embodiments.
[Fig. 5] Fig. 5 is a flowchart of an application method according to embodiments.
[Fig. 6] Fig. 6 is a schematic diagram for explaining a method of sensing a pool as a method according to the present invention, where (A) illustrates lateral views of a nozzle and (B) illustrates top views of a sensing surface.
[Fig. 7] Fig. 7 is a schematic diagram for explaining a method of sensing a pool through trial application, where (A) illustrates lateral views of a nozzle and (B) illustrates top views of a sensing surface.
[Fig. 8] Fig. 8 is a schematic diagram for explaining how a pool emerges and develops at a nozzle tip, where (A) illustrates lateral views of a nozzle, and (B) illustrates bottom views of the nozzle.

### Mode for Carrying out the Invention

In the present invention, the presence of a pool at a bottom end of a nozzle is detected by moving a discharge device downward until the interval between the bottom end of the nozzle and a sensing surface becomes equal to a predetermined sensing distance and sensing whether adhesion of a liquid material is present on the sensing surface. Embodiments of the present invention will be described below.

### <Pool Detection Device>

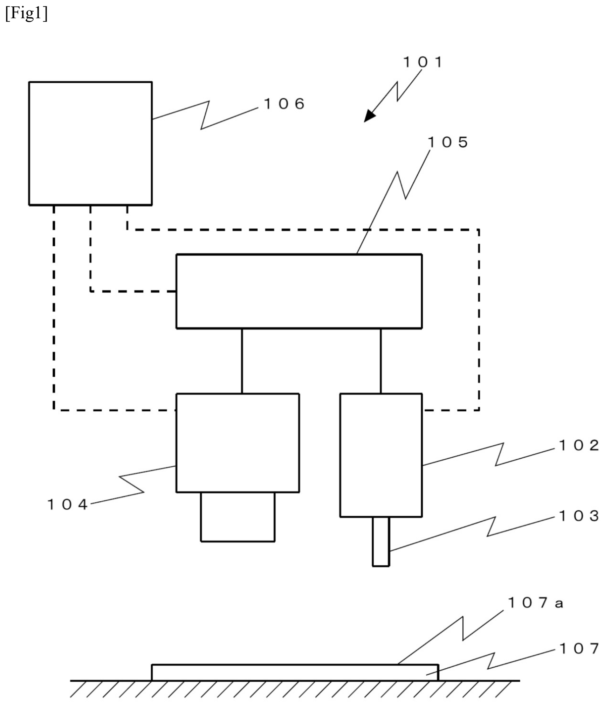

As illustrated in Fig. 1, a pool detection device 101 according to a present embodiment includes a discharge device 102, a sensing device 104, a moving device 105, and a sensing control device 106. Dotted lines extending from the sensing control device 106 are cables for transmitting and receiving control signals.

The discharge device 102 includes a nozzle 103 having one circular discharge port at its tip for discharging a liquid material, and is a so-called flying-discharge type discharge device with which the liquid material having been discharged separates from the nozzle before reaching an application surface. The discharge device 102 is held by the moving device 105 such that the tip of the nozzle 103 is positioned at the bottom end. Examples of the flying-discharge type of discharge devices include: a type in which discharge is performed by reciprocating a rod-shaped member in a liquid chamber communicating with a nozzle to apply inertial force to a liquid material; a type in which discharge is performed by changing a volume of a liquid chamber communicating with a nozzle; a type in which discharge is performed by air bubbles generated on a heat generator provided in a liquid chamber communicating with a nozzle; and the like. In the present embodiment, although a configuration including the cylindrical nozzle extending directly downward is illustrated, the shape of the nozzle is not particularly limited except that the nozzle has a discharge port at its tip. For example, the nozzle may be a tapered nozzle or a curved cylindrical nozzle. Further, the nozzle to which the technical idea of the present invention is applicable is not limited to a nozzle having one discharge port at its cylindrical or substantially cone-shaped tip. For example, the nozzle may be an orifice nozzle having one or more discharge ports formed by drilling its flat bottom surface.

A sensing surface 107a of a member for sensing 107 is a flat surface to which a pool at the tip (bottom end) of the nozzle 103 of the discharge device 102 may adhere when a pool detection method described later is executed. It is sufficient for the member for sensing 107 to have a flat top surface. As the member for sensing 107, for example, a plate-like member, a tape-like member set such that paper, cloth, or the like is stretched in a rollable manner, an unused area of a product board (workpiece), or the like can be used.

The sensing device 104 is a device for sensing whether a liquid material is present on the sensing surface 107a. It is sufficient for the sensing device 104 to be able to sense the presence of the liquid material having adhered to the sensing surface 107a. As the sensing device 104, for example, an image capturing device (camera), a laser displacement meter, an ultrasonic sensor, or the like can be used. The sensing control device 106 detects adhesion of the liquid material to the sensing surface 107a based on signals from the sensing device 104.

The moving device 105 is a device that moves the discharge device 102 and the sensing device 104 relative to the sensing surface 107a. As the moving device 105, for example, a so-called industrial robot that is an orthogonal type, a scalar type, or the like can be used. Although the moving device 105 according to the present embodiment is configured to move the discharge device 102 and the sensing device 104 independently of each other, it may be configured to move the discharge device 102 and the sensing device 104 integrally with each other.

The sensing control device 106 is an information processing device that controls operation of the discharge device 102, the sensing device 104, and the moving device 105 described above and executes the pool detection method described later, and includes an arithmetic device and a storage device. For example, a personal computer (PC), a programmable logic controller (PLC), or the like may be used. The storage device of the sensing control device 106 stores a sensing program for executing the pool detection method of the present invention.

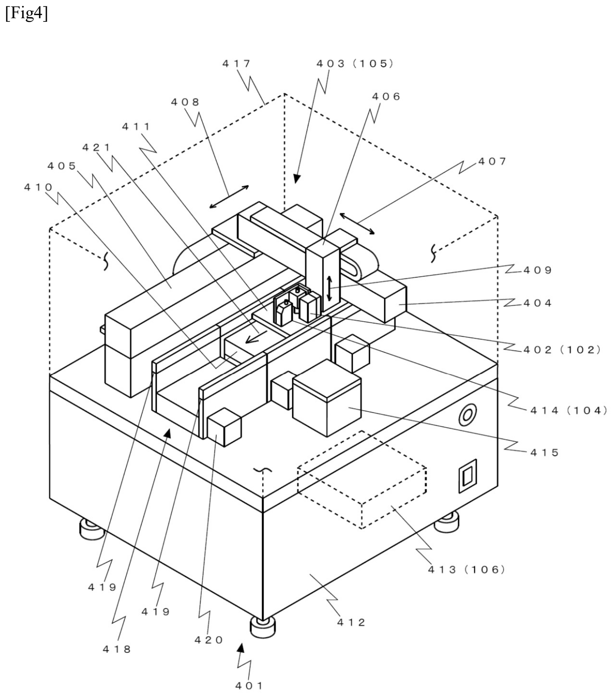

In a case where the above-described pool detection device 101 is incorporated into an application apparatus 401 illustrated in Fig. 4, a calibration table 415, a measuring device 414, a driving device 403, and an application control device 413 described later can be substituted for the member for sensing 107, the sensing device 104, the moving device 105, and the sensing control device 106, respectively, so that increases in apparatus size and cost can be suppressed. In this case, the application control device 413 functions as an application control device that controls operation of the discharge device 102 and the moving device 105 to execute application to a workpiece, and as a sensing control device that controls operation of the sensing device 104 and the moving device 105 to detect a pool at the nozzle tip.

### <Pool Detection Method>

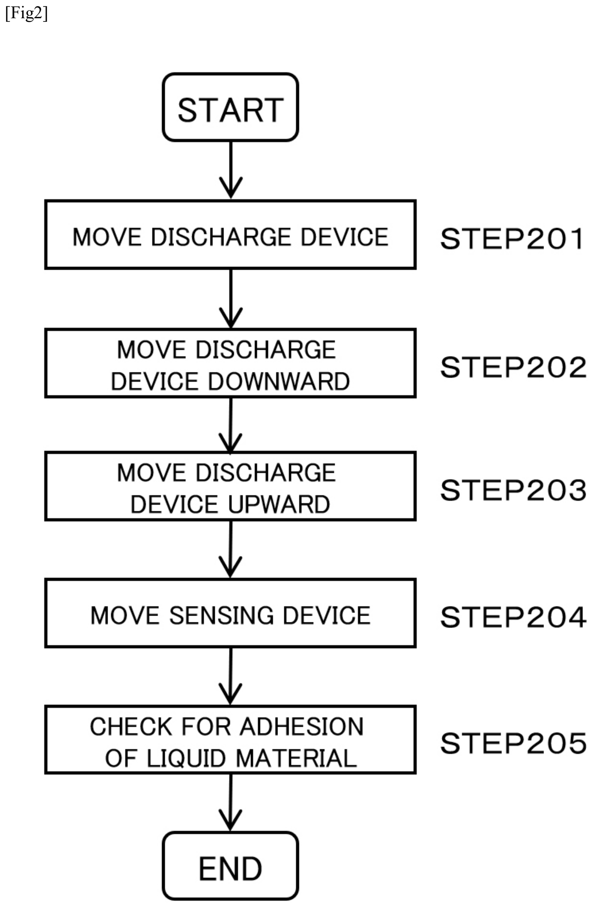

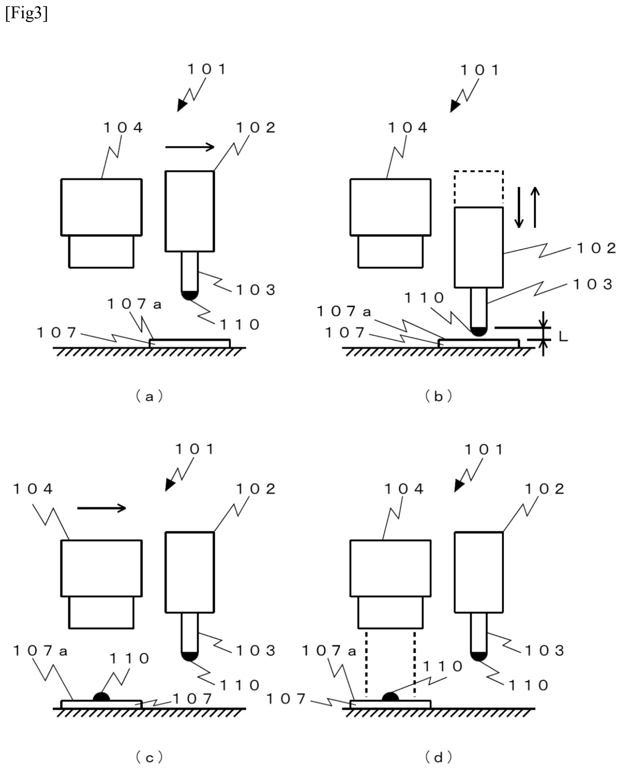

A method for detecting a pool at the tip of the nozzle 103 using the above-described pool detection device 101 will be described. The pool detection method according to the present embodiment is carried out by the sensing control device 106 executing the sensing program. Fig. 2 illustrates a flowchart of a procedure of the pool detection method according to the present embodiment, and Fig. 3 illustrates an explanatory diagram for explaining the procedure of the pool detection method according to the present embodiment.

(STEP 201) First, the moving device 105 moves the discharge device 102 to a sensing position (XY-coordinates) above the sensing surface 107a (Fig. 3 (a)). Here, a Z-position of the discharge device 102 at the sensing position is higher than a Z-coordinate where it is at a predetermined sensing distance L described later. The process of STEP 201 may herein be referred to as a first process.

(STEP 202) Subsequently, the moving device 105 moves the nozzle 103 of the discharge device 102 downward until it reaches the predetermined sensing distance L toward the sensing surface 107a (Fig. 3 (b)). At this time, the discharge device 102 does not perform a discharge operation but, in a case where a pool exceeding an acceptable range has occurred, a liquid material adheres to the sensing surface 107a. Here, the predetermined sensing distance L is determined depending on a pool volume that is expected to be sensed. In other words, the predetermined sensing distance L, which is a distance between the tip of the nozzle 103 and the sensing surface 107a, is determined depending on an acceptable pool volume. In the present embodiment, the acceptable pool volume is specified by a distance from the bottom surface of the nozzle 103 to a protruded end (lower end) of a pool (predetermined sensing distance L). Although there is variation depending on physical properties of a liquid material (such as density and viscosity) and an ambient environment (such as temperature and humidity), the predetermined sensing distance L is preferably set, for example, in a case of a nozzle with a circular tip, to 1/2 to 2 times the outer diameter of the nozzle tip or, in a case of a nozzle with a circular discharge port (including the above-described orifice nozzle), to 1/3 to 7 times the diameter of the discharge port of the nozzle. In a case where the pool volume expected to be sensed is smaller (i.e., earlier stage of pooling), the predetermined sensing distance L is set to be shorter. In a case where the pool volume expected to be sensed can be larger (i.e., later stage of pooling), the predetermined sensing distance L is set to be longer. In addition, the predetermined sensing distance L is preferably set to be shorter than an interval between the nozzle and an application surface at the time of application operation.

(STEP 203) Next, the discharge device 102 of which nozzle 103 is at the predetermined sensing distance L is moved upward and then horizontally from the sensing position by the moving device 105. Here, the discharge device 102 may be moved upward by any movement amount. The process of STEPs 202 and 203 may herein be referred to as a second process.

(STEP 204) Next, the moving device 105 moves the sensing device 104 to a sensing position above the sensing surface 107a (Fig. 3 (c)). The sensing position (XY-coordinates) to which the sensing device 104 is moved is the same as the sensing position (XY-coordinates) to which the discharge device 102 is moved in STEP 201. Here, a Z-position of the sensing device 104 at the sensing position may be any Z-coordinate as long as it does not come into contact with a liquid material above the sensing surface 107a. In a case where the moving device 105 is configured to move the discharge device 102 and the sensing device 104 integrally with each other, the horizontal movement of the discharge device 102 in STEP 203 and the horizontal movement of the sensing device 104 in STEP 204 can be performed at the same time.

(STEP 205) The sensing control device 106 determines whether or not a liquid material 110 adheres to the sensing surface 107a based on a measurement signal from the sensing device 104 (Fig. 3 (d)). When adhesion of the liquid material 110 is present on the sensing surface 107a, it is determined that a pool exceeding the acceptable range has occurred at the tip of the nozzle 103. On the other hand, when adhesion of the liquid material 110 is not present on the sensing surface 107a, it is determined that a pool exceeding the acceptable range has not occurred at the tip of the nozzle 103. The process of STEPs 204 and 205 may herein be referred to as a third process.

As described above, the discharge device 102 is moved closer to the sensing surface 107a without performing a discharge operation until it is at the predetermined sensing distance L, and then further away, and whether or not the liquid material 110 adheres to the sensing surface 107a is checked. This simple approach makes it possible to sense whether an unacceptable pool has occurred at the tip of the nozzle 103 of the discharge device 102. Further, setting the predetermined sensing distance L to be small makes it possible to sense even a pool with a small volume at the tip of the nozzle 103.

### <Application Apparatus>

An application apparatus that performs the above-described pool detection method will be described.

As illustrated in Fig. 4, an application apparatus 401 of the present embodiment mainly includes a discharge device 402 that discharges a liquid material, and a relative driving device 403 that moves the discharge device 402 and a worktable 410, on which an application target (workpiece) 411 is placed, relative to each other.

The relative driving device 403 includes an X-driving device 404, a Y-driving device 405, and a Z-driving device 406 that move the discharge device 402 and the worktable 410 relative to each other in an X-direction 407, a Y-direction 408, and a Z-direction 409, respectively. In the present embodiment, the Y-driving device 405 is provided on an upper surface of a base 412 to extend in the Y-direction 408, and the X-driving device 404 is provided on the Y-driving device 405 to extend in the X-direction 407. The Z-driving device 406 is provided on the X-driving device 404, and the discharge device 402 is provided on the Z-driving device 406. The worktable 410 is installed on the upper surface of the base 412 so as to be positioned parallel to the Y-driving device 405 and below the X-driving device 404. This configuration allows the discharge device 402 and the application target 411 on the worktable 410 to move relative to each other in the X-direction 407, the Y-direction 408, and the Z-direction 409. The relative driving device 403 can move a nozzle tip of the discharge device 402 to any position above the application target 411 at any speed under control of the application control device 413. Examples of devices that can be used as the relative driving device 403 include: a combined device of an electric motor, such as a servomotor or a stepping motor, and a ball screw; a device using a linear motor; and a device having a belt or a chain to transmit power. The relative driving device 403 is also used as the moving device 105 of the pool detection device 101.

The discharge device 402 includes a nozzle for discharging the liquid material, and operation thereof is controlled by the application control device 413. The application control device 413 can control the discharge device 402 in conjunction with operation of the relative driving device 403. As the discharge device 402, a flying-discharge type discharge device (dispenser) is used. The discharge device 402 corresponds to the discharge device 102 of the pool detection device 101 illustrated in Fig. 1. The discharge device 402 is held by the relative driving device 403 such that the nozzle tip is at the bottom end.

The application apparatus 401 according to the present embodiment includes a transport device 418. The transport device 418 includes a rail 419, a transmission element (not illustrated), and a transport driving device 420. The rail 419 includes two members extending parallel to each other in the Y-direction 408. The rail 419 is installed such that the distance between the two members is the same as a length of one side of the application target 411. The rail 419 is equipped with the transmission element that acts to transport the application target 411 along the extending direction of the rail 419. A belt, a chain, or the like can be used as the transmission element. The transmission element is driven by the transport driving device 420. An electric motor such as a servomotor or a stepping motor can be used as the transport driving device 420. By the action of the transmission element driven by the transport driving device 420, the application target 411 is transported in a transport direction 421 along the rail 419. The transport device 418 is connected to the application control device 413, which controls a transport speed, start and stop of transport, and the like.

The worktable 410 including a rectangular parallelepiped member can be lifted and lowered by a lifting and lowering device (not illustrated). The worktable 410 is installed between the rail members 419 of the transport device 418. A width of the worktable 410 in the X-direction 407 is slightly smaller than the distance between the rail members 419 of the transport device 418 so as not to come into contact with the rail members 419 of the transport device 418. When the application target 411 is transported, the worktable 410 is lowered to a position where it does not come into contact with the application target 411. When application work is performed on the application target 411, the worktable 410 is lifted so that the application target 411 can be fixed between the worktable 410 and a retaining plate (not illustrated) provided on the rail 419. In order to more securely fix the application target 411, this mechanism may be used, for example, together with a mechanism that sucks and fixes the application target 411 by sucking the air through a plurality of holes leading from an inside of the worktable 410 to an upper surface thereof.

The application apparatus 401 of the present embodiment may be equipped with a measuring device 414. The measuring device 414 is provided on the Z-driving device 406 together with the discharge device 402, and can be moved relative to the application target 411 on the worktable 410. The measuring device 414 may include, for example, an image capturing device and a ranging device. The image capturing device can capture images of a component, an identification mark, and an applied liquid material on the application target 411. A CCD camera or the like can be used as the image capturing device. The ranging device can measure a distance to a surface of the application target 411, a surface of a component on the application target 411, or a surface of a liquid material applied to the application target 411. The heights of a component and an applied liquid material can be obtained from the measured values. A laser displacement meter or the like can be used as the ranging device. Images captured by the image capturing device and distances measured by the ranging device are used for checking a state of an applied liquid material, alignment of the nozzle of the discharge device 402 with respect to the application target 411, and the like. The image capturing device and the ranging device may be integrally provided via a mounting plate. The measuring device 414 is connected to the application control device 413, which can control operation thereof and can store and process measurements. The measuring device 414 is also used as the sensing device 104 of the pool detection device 101.

The application apparatus 401 according to the present embodiment includes a calibration table 415. The calibration table 415 is installed near the worktable 410 on the upper surface of the base 412 within a range where the discharge device 402 can be moved by the relative driving device 403. The calibration table 415 includes a surface (upper surface) to which a liquid material can be applied. This surface constitutes a sensing surface. A liquid material is applied to this surface, and a shape and a size of the applied liquid material are checked with the above-described measuring device. Based on the results, adjustment can be made to ensure the liquid material is applied to the application target 411 in a desired shape and size. Instead of the above configuration, a plate-like body with a surface to which a liquid material can be applied may be separately prepared and fixed by the above-described suction and fixation mechanism, thereby forming the calibration table 415. The calibration table 415 is also used as the member for sensing 107 including the sensing surface 107a of the pool detection device 101.

The application control device 413 includes a processing device, a storage device, an input device, an output device, and a display device. In the present embodiment, the application control device 413 is constituted by: an information processing device having the processing device and the storage device which are integrated therein; and a touch panel (not illustrated) used as the input device, the output device, and the display device. However, the present invention is not limited to this configuration. A personal computer (PC), a programmable logic controller (PLC), or the like can be used as the information processing device, and a keyboard, a mouse, and a display can be used as the input device, the output device, and the display device.

The application apparatus 401 according to the present embodiment can be connected to an instruction terminal not illustrated. With the instruction terminal, it is possible to give instructions on positioning of the relative driving device 403, operation of the discharge device 402, and the like. The application control device 413 stores the instructions. The application control device 413 can sequentially set a plurality of related instructions to execute them as a sequence of instructions. In other words, the application control device 413 includes an application program for operating the discharge device 402 and the relative driving device 403 according to the instructions. Examples of available instruction terminals include: a dedicated terminal including a simple display device and a plurality of switches; and a personal computer with dedicated software installed. With the instruction terminal, it is possible to start and stop operation of the application apparatus 401 based on the application program stored in the application control device 413. Instead of the instruction terminal, the above-described application control device 413 and the touch panel can be used to give instructions.

The application control device 413 stores the above-described sensing program in the storage device, and can execute the pool detection method according to the present embodiment by executing the sensing program. Although a configuration in which the application control device 413 is also used as the above-described sensing control device 106 is adopted in the embodiment illustrated in Fig. 4, a sensing control device physically separated from an application control device may be provided.

A top of the base 412, on which the discharge device 402, the relative driving device 403, the worktable 410, and the like are provided, is covered by a cover 417 represented by dotted lines. In Fig. 4, a part of the cover 417 is not drawn for convenience of explanation. With the cover 417, it is possible to prevent dust from entering the application apparatus 401, and prevent careless contact between an operator and a moving portion of the relative driving device 403 or the like. Although not illustrated, the cover 417 may have an openable door for the operator to easily access the application apparatus 401. The cover 417 may be provided with the above-described touch panel so that the application apparatus 401 can also be operated from outside the cover 417. Further, the cover 417 may have an opening for the application target 411 to be imported into or exported from the application apparatus 401.

### <Application Method>

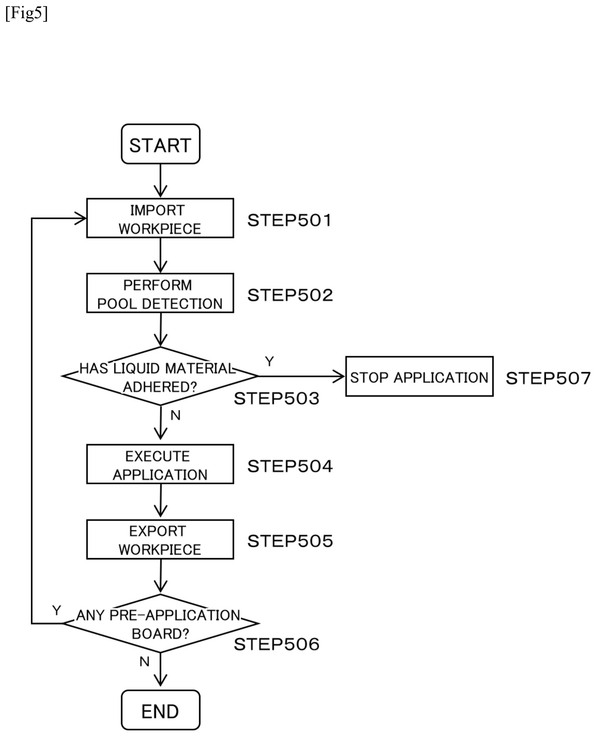

An application method using the above-described application apparatus will be described. The application method according to the present embodiment is carried out by the application control device 413 executing the application program. Fig. 5 illustrates a flowchart of the application method according to the present embodiment. In the application method described with reference to Fig. 5, detection of a pool at a nozzle tip is performed at the beginning of application work. However, it is naturally possible to perform the detection of a pool at a nozzle tip after the application work (that is, application process) has been executed on a predetermined number of workpieces.

When an application operation start command is issued, the transport device 418 imports a pre-application board to be processed as the application target 411 into the application apparatus (STEP 501). Next, the above-described pool detection method (STEPs 201 to 205 in Fig. 2) of the embodiment is carried out (STEP 502). In a case where execution of the pool detection method results in the determination that adhesion of a liquid material has occurred on the upper surface of the calibration table 415 as the sensing surface, the processing proceeds to STEP 507 described later, and in a case where adhesion of the liquid material has not occurred on the sensing surface (calibration table), application is executed while the discharge device 402 is moved relative to the board by the relative driving device 403 (STEPs 503, 504). Then, the transport device 418 exports the post-application board from the application apparatus (STEP 505). When there remains a pre-application board to be processed as the application target 411, the processing returns to STEP 501, where the pre-application board is imported into the application apparatus. When there remains no pre-application board, the operation is ended (STEP 506).

In a case where adhesion of the liquid material to the sensing surface is found in STEP 503, it means that a pool has occurred at the nozzle tip of the discharge device, and thus the application is stopped for cleaning the nozzle (STEP 507). For example, a configuration may be adopted that automatically cleans the nozzle tip by a cleaning device such as a washing device, not illustrated, which is installed on the base 412 and wipes off, sucks, or blows off the liquid material having pooled at the nozzle tip. With such a configuration, it is possible to automatically resume the application operation after the cleaning (that is, to execute a post-cleaning application process). Alternatively, just alert notification described later may be made to prompt an operator to demount, disassemble, and wash the discharge device. That is, a notification device may be provided to make notification with an alert that can be visually or aurally recognized when adhesion of the liquid material to the sensing surface is found in STEP 503. For example, the application apparatus 401 may include a speaker emitting sound (not illustrated), a light-emitting device emitting light, a display device displaying an alert on its screen, or the like to make notification, or may transmit a command signal notifying an external device connected by wire or wirelessly of abnormality.

The above-described pool detection method may be performed during the operation of importing/exporting a board (application target 411) to/from the application position. Further, the pool detection method may be carried out when a set condition related to execution timing (for example, the number of times of application) is satisfied, instead of being performed each time the application method is executed. For example, the above-described pool detection method may be carried out each time the application work is performed a set number of times, such as 5 or 10 times, or each time a set period of time elapses. When the acceptable pool volume is large, the interval for performing the pool detection step can be set to be longer than a standard execution interval to reduce the number of times the pool detection step is executed, leading to improved productivity.

Further, single detection of adhesion of a liquid material to the sensing surface by the above-described pool detection method may not lead to a conclusion that an unacceptable pool has occurred. Instead, when the cumulative number of times of detection reaches more than one (or three or more) or the number of times of detection in a row reaches more than one (or three or more), it may be concluded that an unacceptable pool has occurred. This can prevent application work from being stopped due to a temporarily-large pool or false detection.

According to the pool detection method of the present embodiment described above, occurrence of a pool exceeding an acceptable range is determined based on whether a liquid has adhered to the sensing surface. Therefore, it is possible to perform highly-accurate determination without false sensing.

Further, the predetermined sensing distance L can be easily changed, which makes it possible to flexibly change the acceptable pool volume depending on the intended use. For example, when the acceptable pool volume is small, the predetermined sensing distance L may be set to be shorter than a standard value, and when the acceptable pool volume is large, the predetermined sensing distance L may be set to be longer than the standard value.

Further, the sensing device can be mounted on the moving device for relative movement of the discharge device to detect a pool, which eliminates the need to increase the size of the application apparatus and results in minimal addition of equipment.

The preferred embodiment examples of the present invention have been described above. However, the technical scope of the present invention is not limited to the descriptions of the above-described embodiments. Various alterations and modifications can be applied to the above-described embodiment examples, and such altered or modified modes also fall within the technical scope of the present invention.

For example, although the flying-discharge type discharge device (dispenser) is illustrated as a discharge device in the embodiments, the technical scope of the present invention is also applicable to various discharge types of discharge devices, such as an air type in which discharge is performed by air pressure, and a screw type in which discharge is performed by screw rotation.

Although the sensing device can be moved by the moving device in the embodiments, the sensing device may be fixedly installed.

Although the application apparatus 401 in which one discharge device 402 is provided on the Z-driving device 406 is illustrated in the embodiments, the technical scope of the present invention is also applicable to a mode in which a plurality of discharge devices are provided on the relative driving device.

### List of Reference Symbols

101: pool detection device / 102, 402: discharge device / 103, 601, 701, 801: nozzle / 104: sensing device / 105: moving device / 106: sensing control device / 107: member for sensing/ 107a, 602a, 702a: sensing surface / 110, 603, 703, 804: liquid material / 401: application apparatus / 403: relative driving device / 404: X-driving device / 405: Y-driving device / 406: Z-driving device / 407: X-movement direction / 408: Y-movement direction / 409: Z-movement direction / 410: worktable / 411: application target (workpiece) / 412: base / 413: application control device / 414: measuring device / 415: calibration table / 417: cover / 418: transport device / 419: rail / 420: transport driving device / 421: transport direction / 702: application surface / 802: hole portion / 803: wall portion

## Claims

1. A nozzle bottom pool detection method for detecting a pool at a bottom end of a nozzle of a liquid material discharge device, the nozzle bottom pool detection method comprising:
a first process of moving the nozzle to a sensing position above a sensing surface;
a second process of moving the nozzle downward until an interval between the bottom end of the nozzle and the sensing surface becomes equal to a predetermined sensing distance and moving the nozzle upward upon the interval reaching the predetermined sensing distance; and
a third process of detecting a pool at the bottom end of the nozzle by a sensing device sensing whether a liquid material adheres to the sensing surface.

2. The nozzle bottom pool detection method according to claim 1, wherein the liquid material is not discharged from the nozzle during execution of the second process.

3. The nozzle bottom pool detection method according to claim 1, wherein the nozzle is a nozzle having one discharge port at the bottom end.

4. The nozzle bottom pool detection method according to claim 1, wherein the nozzle is a nozzle having a cylindrical or tapered shape.

5. The nozzle bottom pool detection method according to claim 1, wherein the sensing device is any of an image capturing device, a laser displacement meter, and an ultrasonic sensor.

6. The nozzle bottom pool detection method according to claim 1, wherein the sensing surface is any of an upper surface of a plate-like member for sensing, an upper surface of a tape-like member, and an unused area of an upper surface of a workpiece.

7. The nozzle bottom pool detection method according to claim 1, wherein the predetermined sensing distance is set within a range of 1/2 to 2 times an outer diameter of the bottom end of the nozzle, or 1/3 to 7 times a diameter of a discharge port of the nozzle.

8. A liquid material application method comprising:
an application process of discharging a liquid material from the nozzle to a workpiece; and
a pool detection process of executing the nozzle bottom pool detection method according to any one of claims 1 to 7 before or after executing the application process.

9. The liquid material application method according to claim 8, further comprising a process of cleaning the bottom end of the nozzle when it has been detected in the pool detection process that the liquid material adheres to the sensing surface.

10. The liquid material application method according to claim 9, comprising a post-cleaning application process of discharging the liquid material from the nozzle to the workpiece after executing the cleaning.

11. The liquid material application method according to claim 8, further comprising, when a pool of which volume is not acceptable has been detected at the bottom end of the nozzle in the pool detection process, issuing an alert that can be visually or aurally recognized or transmitting a command signal to notify an external device of abnormality, and stopping execution of the application process.

12. The liquid material application method according to claim 8, further comprising:
an importing process of importing the workpiece to an application position, the importing process being performed before the application process; and
an exporting process of exporting the workpiece from the application position, the exporting process being performed after the application process,
wherein the pool detection process is executed concurrently with any of the importing process and the exporting process.

13. A nozzle bottom pool detection device comprising:
a moving device configured to move a discharge device having a nozzle above a sensing surface;
a sensing device configured to sense a liquid material having adhered to the sensing surface; and
a sensing control device configured to control operation of the moving device and the sensing device,
wherein
the sensing control device is configured to execute: a first step of causing the moving device to move the nozzle above the sensing surface;
a second step of causing the nozzle to move downward until an interval between a bottom end of the nozzle and the sensing surface becomes equal to a predetermined sensing distance and move upward upon the interval reaching the predetermined sensing distance; and
a third step of causing the sensing device to sense whether the liquid material adheres to the sensing surface thereby detecting a pool at the bottom end of the nozzle.

14. The nozzle bottom pool detection device according to claim 13, wherein the sensing control device includes a function of setting the predetermined sensing distance.

15. The nozzle bottom pool detection device according to claim 13, wherein the moving device is capable of moving the sensing device above the sensing surface.

16. An application apparatus comprising:
the nozzle bottom pool detection device according to any one of claims 13 to 15;
a discharge device having a nozzle;
a worktable configured to hold a workpiece;
a base on which the worktable is disposed;
a transport device configured to transport the workpiece to the worktable; and
an application control device configured to control operation of the discharge device and the moving device, wherein
the application apparatus performs application on the workpiece while causing the moving device to move the discharge device and the workpiece relative to each other based on a relative movement command from the application control device.

17. The application apparatus according to claim 16, further comprising, on the base, a cleaning device configured to clean the bottom end of the nozzle,
wherein the sensing control device is configured to execute a fourth step of causing the cleaning device to clean the bottom end of the nozzle when it has been detected in the third step that the liquid material adheres to the sensing surface.

18. The application apparatus according to claim 16, further comprising a notification device configured to issue an alert that can be visually or aurally recognized,
wherein the sensing control device is configured to execute a fourth step of causing the notification device to issue the alert when it has been detected in the third step that the liquid material adheres to the sensing surface.

19. The application apparatus according to claim 16, wherein the sensing control device includes a function of setting a timing-related condition for executing the first to third steps.

20. The application apparatus according to claim 16, wherein the discharge device is a flying-discharge type dispenser configured to discharge and fly a droplet from a discharge port of the nozzle.
